# EUROPEAN PATENT APPLICATION

(11) **EP 2 529 861 A1**
(43) Date of publication of application: **05.12.2012**
(21) Application number: 11168094.8
(22) Date of filing: 30.05.2011
(51) Int. Cl.: B22F 1/00, B22F 1/02, B22F 9/24, H01L 21/304, H05K 3/10

(54) **Synthesis of Nanoparticles comprising oxidation sensitive metals with Tuned Particle Size and High Oxidation Stability**

(71) Applicant: Bayer Intellectual Property GmbH, 40789 Monheim (DE)
(72) Inventor: Rauscher, Frank, Dr., Clawson, MI 48017 (DE); Feldmann, Claus, Prof. Dr., 76275 Ettlingen (DE); Kind, Christian, 76470 Ötigheim (DE); Lu, Huachang, Dr., 50858 Köln (DE); Köhler, Karen, Dr., 51069 Köln (DE); Mleczko, Leslaw, Prof. Dr., 41542 Dormagen (DE)
(74) Representative: Bayer Intellectual Property GmbH

(57) **Abstract**

Process for the synthesis of nanoparticles comprising oxidation sensitive metals, in particular copper comprising the following steps:
- Preparation and nucleation of citrate-capped Metal-hydroxide nanoparticles,
- reduction of the intermediate citrate-capped Metal-hydroxide nanoparticles to Metal⁰ by reduction via NaBH₄

Cu⁰ nanoparticles with narrow size distribution are obtained by NaBH₄-induced reduction of CuCl₂·2H₂O in diethylene glycol. The course of the reaction essentially involves an intermediate formation of Cu(OH)₂ nanoparticles as well as the presence of citrate to control the nucleation of almost monodisperse and non-agglomerated Cu⁰ nanoparticles. The citrate-capped Cu⁰ nanoparticles of the invention are surprisingly stable against air oxidation. Via simple solvent evaporation, porous Cu⁰ thin-films are prepared on glass substrates that exhibit bulk-like sheet resistances of 0.23 - 0.42 Ω_{□} after vacuum sintering at 250 °C (bulk-Cu sheet under similar conditions with: 0.3 Ω_{□}). With these features the as-prepared, citrate-capped Cu⁰ nanoparticles become highly relevant to electronic devices in particular thin-film electronics, thin-film sensors and high-power batteries.

## Description

The invention relates to the synthesis of nanoparticles comprising oxidation sensitive metals in particular Cu⁰ with tuned particle size and high oxidation stability and electrodes with bulk-like conductivity comprising prepared nanoparticles.

Silver and copper thin-films are highly requested for all kinds of printed electronics, for instance, radio-frequency identification (RFID) tags, thin-film transistors (TFT), ultra high frequency (UHF) antennas, membrane keyboards, solar cells or battery testers. To this concern, silver is currently applied most often. Its strongly increasing spot price and concerns regarding its biocide properties, however, strongly trigger a replacement by copper. Here, questions arise regarding suitable printing techniques and precursor materials. The first aspect is yet tackled by electrodeposition or chemical vapour deposition, followed by wasteful lithographic etching in order to realize structured electrodes (P. C. Andricacos, Interface, 1999, 32). Precursor inks containing organometalic copper compounds bring along restrictions such as advanced, multistep synthesis and high costs. In some cases a severe toxicity of precursors and organic solvents, the need of annealing processes and vacuum techniques for precursor decomposition and removal of volatiles has to be considered (Rickerby et al. Chem. Rev., 2002, 102, 1525). Annealing processes turned out to be troublesome, in general, due to poisoning of circuits and partial re-oxidation of copper making conductivity much less than bulk. Moreover, annealing precludes paper or plastics as low-cost substrates.

To establish a straight-forward manufacturing of thin-film copper electrodes based on common printing techniques (e.g., dip- or spin-coating, ink-jet, off-set or silk-screen printing) several strategies have been followed. This includes usage of molten metals (WO 2007038987) suspensions containing nanoscale metal particles (B. K. Park et al. Thin Solid Films, 2007, 515, 7706; S. Gamerith et al. Adv. Funct. Mater., 2007, 17, 3111 ; Y. Wu et al. J. Am. Chem. Soc., 2006, 128, 4202; H. H. Lee et al. Nanotechnol., 2005, 16, 2436), and solutions of organometalic precursor molecules (P. J. Smith et al. J. Mater. Sci., 2006, 41, 4153; Z. Liu et al. Thin Solid Films, 2005, 478, 275; G. G. Rozenberg et al. Appl. Phys. Lett., 2002, 81, 5249). Moreover, self-reducing precursors and electrodeposition processes have been suggested as more elaborate methods (JP 2008190020; T. Osaka et al.Electrochim. Acta, 2007, 53, 271). Although the resulting electrical properties are quite comparable to the specific resistance of bulk copper (1.7·10⁻⁶Ω cm) restrictions due to advanced and expensive precursors and/or thermal treatment at elevated temperatures (typically 200-250 °C, e.g., for precursor decomposition, removal of volatiles) are still unsolved. The nanoparticulate route towards thin-film copper electronics is to date mainly limited by the high reactivity of Cu⁰ nanoparticles. Reoxidation typically occurs right after synthesis and during purification steps (M. Abdulla al-Mamun et al. Mater. Lett. 2009, 63, 2007) or within hours to a few days (P. Kanninen et al. J. Colloid Interface Sci. 2008, 318, 88). Liquid-phase synthesis of Cu⁰ nanoparticles that are stable against reoxidation for weeks has been twice reported very recently, however, with high molecular weight poly(N-vinylpyrrolidone) (PVP) as a polymer stabilizer (Y. Lee et al Nanotechnol. 2008, 19, 415604; V. Engels et al Dalton Trans. 2010, 39, 6496). The disadvantage of PVP is that this polymer builds layers on the nanoparticles which at least negatively influence or even cut the sintering of produced particles and PVP coating is more difficult to remove after synthesis.

Therefore there is a need for a facile synthesis of nanoparticles comprising oxidation sensitive metals in particular Cu⁰ or In⁰ (further referred to as Me) that allows controlling the particle size, high oxidation stability and that does neither require advanced precursors nor elaborate inert conditions.

The problem was solved by the preparation of Me⁰ comprising nanoparticles in a facile synthesis via reduction of a metal salts with a reducing agent in the presence of bi- or tri-functional organic carboxylic acids as a capping agent in a high boiling alcohol.

The method of the present invention was found to be particularly suitable for metals or alloys comprising with Redox-potential from -0.9 to +0.9 V, preferably -0.5 to +0.5 V such as Cu^{II}/Cu⁰ (E₀ = +0.34 V), In^{III}/In⁰ (E₀ = -0.34 V), Zn^{II}/Zn⁰ (E₀ = -0.76 V), Fe^{II}/Fe⁰ (E₀ = -0.44 V), Ag^{I}/Ag⁰ (E₀ = +0.80 V), Fe^{III}/Fe⁰ (E₀ = -0.77 V), Sn^{II}/Sn⁰ (E⁰ = -0.14 V), Bi^{III}/Bi⁰ (E⁰ = +0.31 V), Pb^{II}/Pb⁰ (E⁰ = -0.13).

First object of the present invention is therefore a process for the synthesis of nanoparticles comprising one or more oxidation sensitive metal via reduction of metal salts with a reducing agent in the presence of bi- or tri-functional organic carboxylic acids as a capping agent in a high boiling alcohol.

Adequate Metal-salts are Me-hydroxides or all salts able to be converted into a metal-hydroxide in particular readily commercially available Metal-sulfates, -nitrates, -halogenes, e.g. Metal-chlorides, such as CuCl₂·2H₂O, InCl₃.4H₂O.

Suitable capping agents are bi- or tri-functional organic carboxylic acids such as salts of citric, oxalic acids, etc...

Suitable reducing agents are for example aluminium hydride salts such as lithium aluminium hydride (LiAlH₄) or other, borohydride salts such as sodium or potassium borohydride, sulfite compounds, hydrazine (Wolff-Kishner reduction), diisobutylaluminum hydride (DIBAH), Lindlar catalyst, oxalic acid (C₂H₂O₄), Formic acid (HCOOH), Ascorbic acid (C₆H₈O₆), phosphites, hypophosphites, and phosphorous acid.

Adequate high boiling alcohols have a boiling point ≥ 100 °C and are typically selected from the group comprising glycol, butanediol, diethylene glycol (DEG), diethylene glycol ethers (e.g. diethylene glycol diethyl ether, diglyme), glycerine or polyethylene glycol (PEG), preferably DEG, or mixtures thereof as well as mixed with ethanol or isopropanol.

Ratio of Me-salt and capping agent are typically from 1:0.5 to 1:1.5, preferably 1:0.6 to 1:0.8.

Suitable concentrations of Me-salts in the high boiling alcohol are typically 0.001 to 0.1 M, preferably 0.005 to 0.05 M. Typically flowable reaction mixture with a viscosity below 50 mPas preferably below 10 mPas homogeneity are preferred in particular for continuous preparation in a microreactor system.

Ratio of Me-salt:reducing agent is typically from 1:0.5 to 1:25, preferably 1:2 to 1:10. It was found that the size of the nanoparticles may be controlled by varying the amount of reducing agent used.

For better control of addition it is preferred that reducing agent is added as a solution in used high boiling alcohol or water. Typically a concentration from 0.1 to 15.0 M, preferably 0.1 to 0.5 M is used. It may be advantageous to adapt pH to help stabilizing the reducing agent solution.
Flowable reducing agent solution with a viscosity below 50 mPas preferably below 10 mPas homogeneity are particularly preferred for continuous preparation in a microreactor system.

As a result, non-agglomerated oxidation-stabile Me⁰ nanoparticles with a mean diameter of 1 to 160 nm, preferably 1 to 100 nm most preferably 10 to 50 nm can be obtained.

In particular In⁰ was obtained in a one-pot synthesis via reduction of InCl₃.4H₂O in DEG initiated with indium borohydride in the presence of citrate as a capping agent.

Citrate-capping is well-known to control nucleation and colloidal stability of nanoparticles. Citrate-capping has been used for the liquid-phase synthesis of metals such as Au, Co, Ag, Pd, Pt (P. P. Edwards et al. Angew. Chem. Int. Ed. 2007, 46, 5480; G. Mpourmpakiset al. Phys. Rev. Lett. 2009, 102, 155505, J. Y. Park ET AL : Nano Lett. 2008, 8, 2388, A. M. Schwartzberg et al. J. Phys. Chem. B 2006, 110, 19935). M. Samim et al. report the synthesis of Cu⁰ nanoparticles by reducing an aqueous solution of copper ions with sodium borohydride an in situ capping the metallic nanoparticles with citrate ions to control the particle size. Prepared nanoparticles showed increased efficiency as a catalyst in Ullmann reactions, oxidation stability of produced nanoparticles is not mentioned (Bull. Mater. Sci. 2007, 30, 535).

The essential role of the citrate-capping for the formation and oxidation stability of the In⁰ nanoparticles qualitatively was confirmed experimentally in example 3. It was found that the size of the In⁰ nanoparticles can be controlled by varying the amount of reducing agent used. Nanoparticles from 8 to 105 nm size could be obtained simply in varying the amount of reducing agent.

Oxidation-stable Cu⁰ nanoparticles were obtained in a one-pot synthesis via with NaBH₄-initiated reduction of CuCl₂.2H₂O in DEG in the presence of citrate as a capping agent. The synthesis thereby preferably comprises two steps: a) preparation and nucleation of intermediate citrate-capped Cu-comprising nanoparticles (probably Cu(OH)₂ or Cu₃(C₆H₅O₇)₂), b) reduction of the intermediate citrate-capped Cu-comprising nanoparticles to Cu⁰ by reduction via NaBH₄. Typically the formation of a deep cyan / green suspension is observed in step a). Suspensions, powders as well as thin-films of as-prepared Cu⁰ exhibit surprisingly high oxidation stability when stored in contact to air and even when heated in air to 120°C. Such stability of Cu⁰ comprising nanoparticles is shown first and highly relevant to application in thin-film electronics.

The essential role of the citrate-capping for the formation and oxidation stability of the Cu⁰ nanoparticles qualitatively becomes obvious based on the fact that the absence of citrate results in massively agglomerated copper particles with diameters largely exceeding 100 nm. Without citrate the obtained copper particles are moreover much less stable against air oxidation. X-ray powder diffraction (=XRD) analysis indicates the formation of copper oxides when leaving the powder samples for just some hours in contact to air.

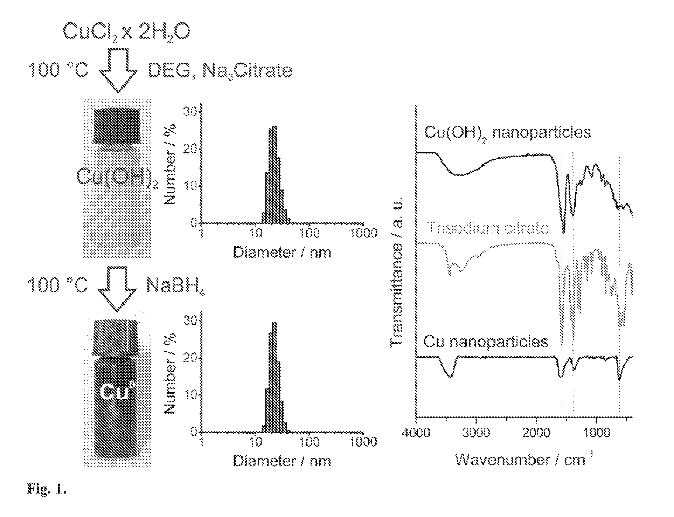

To verify the influence of the intermediate nucleation on the particle stability experiments at different [OH-] concentrations were carried out. Typically, the nanoparticles showed an increased tendency for agglomeration and/or reoxidation if the nucleation was prevented during the synthesis. The course of the reaction involves transient Cu-comprising nanoparticles as well as the presence of citrate to control the nucleation of almost monodisperse and non-agglomerated Cu⁰ nanoparticles. This points to the essential role of citrate that is adsorbed via its carboxyl groups to the OH-terminated surface of the transient Cu-comprising nanoparticles (Figure 1). The protective shell also guarantees for an adequate stabilization of the Cu⁰ nanoparticles right after the chemical conversion of the transient Cu-comprising nanoparticles. As a result, non-agglomerated Cu⁰ nanoparticles with a mean diameter of 1 to 160 nm, preferably 1 to 100 nm most preferably 10 to 50 nm can be obtained.

Therefore it is preferred that the method of the present invention comprises two steps: preparation and nucleation of capped Me-comprising nanoparticles, reduction of the intermediate capped Me-comprising nanoparticles to Me⁰ by reduction via the reducing agent.

A [OH-] concentration of 0.01 to 0.1 M, preferably 0.03 to 0.06 M is preferred to promote Me(OH)ₓ nucleation.

Heating may also be used to promote nucleation of the intermediate capped Me-comprising nanoparticles, reduction or both. Typically the method of the present invention is conducted at a reaction temperature from room temperature (usually 20°C) to 200°C, preferably 20 to 110°C.

The process of the invention can be conducted batchwise or in a continuous way. For the continuous synthesis the method of the present invention is usually conducted in a microreactor system comprising elements selected from the group comprising pumping systems, micromixers, residence microreactors and heat exchanger, wherein micromixers and residence reactors may also comprise micro heat exchangers and elements are connected with each other so the reaction mixture flows continuously from one to the next element.

Typically the nanoparticles prepared according to the method of the present invention are then carefully washed via repeated centrifugation/redispersion in/from mixtures of adequate solvents usually methanol, ethanol or isopropanol or mixtures thereof.

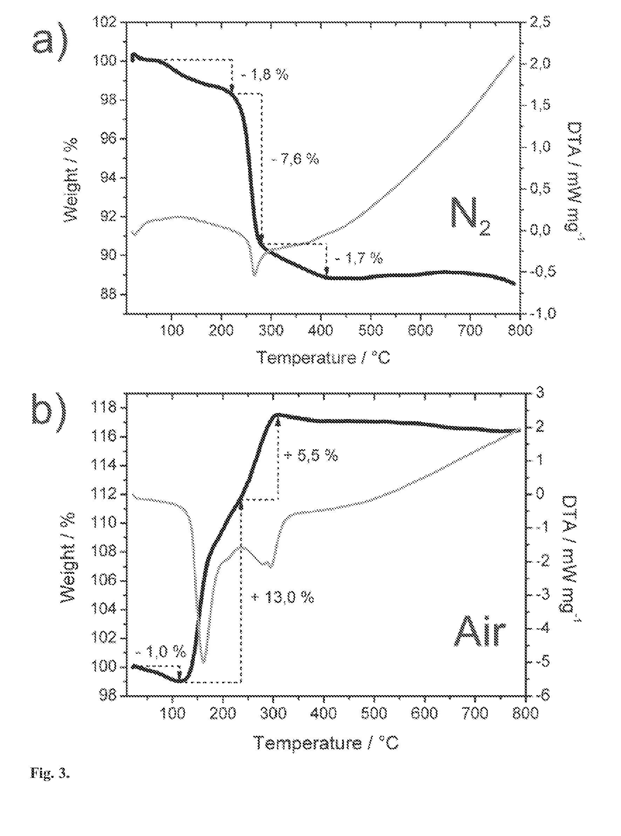

As an example Cu⁰ nanoparticles are resuspended in isopropanol or DEG, usually forming deep black suspensions. Adequately diluted suspensions (i.e. Cu⁰≤1 wt-%) do not show any appreciable sedimentation for weeks (Figure 3). If the particle concentration exceeds 1 wt-%, the suspensions still show just a minor sedimentation after a couple of days. Size, size distribution and degree of agglomeration of produced nanoparticles were investigated by dynamic light scattering (Cu⁰ in DEG, Figure 1). Fig. 1 shows a narrow size distribution of 15-45 nm and a mean diameter of 21(4) nm were obtained. This value is well in accordance with the size of the initial Cu(OH)₂ nanoparticles, too. Surprisingly, the as-prepared and citrate-capped Cu⁰ nanoparticles also turned out to be highly stable against air oxidation. Cu⁰ powder samples do not show any oxide impurities even when left in contact to air for 9 months. Even heating to 120°C in air is tolerable.

Another object of the present invention is therefore a nanoparticle comprising one or more oxidation sensitive metal obtainable by the method of the invention, more particularly oxidation stabile nanoparticles with a mean diameter of 1 to 160 nm, most particularly nanoparticle comprising Indium or Copper metal.

Via simple solvent evaporation, porous Cu⁰ thin-films can be prepared on glass substrates that after vacuum sintering at 250°C exhibit bulk-like behaviour with specific resistance of 6.4·10⁻⁴ Ω cm. Based on this proof of concept significantly improved layers (e.g. with concern to homogeneity and density), and thereby increased conductivities are to be expected while applying professional printing technologies. A further cost advantage may arise by the use of its formulations - as ink and paste - in high-quality printing techniques for the mask-less production of structured conductive electrodes.

Another object of the present invention is therefore an ink comprising the nanoparticle of the present invention.

Oxidation stable citrate-capped Cu⁰ or In⁰ nanoparticles of the invention may become highly relevant for thin-film electronics, light-emitting diode, thin-film solar cell, polymer solar cell, sensors or high-power batteries etc.

A further object of the present invention is therefore a device comprising the nanoparticles of the present invention in particular electronic devices, preferably printed electronic devices.

### Experimental Section:

The method of the present invention is exemplified in the following examples without being restricted thereof.

### Description of figures:

**Figure 1****.** Photos, size distribution and FT-IR spectra along the course of the reaction: (1) nucleation of intermediate Cu(OH)₂ nanoparticles; (2) reduction to Cu⁰ nanoparticles. Size distributions according to DLS analysis after redispersion of the nanoparticles in DEG; FT-IR spectra of citrate-capped Cu(OH)₂ and Cu⁰ nanoparticles (black lines) with trisodium citrate as a reference (grey line).
**Figure 2****.** Optical properties of citrate-capped Cu⁰ nanoparticles: UV-Vis spectrum (left) and photo of a diluted suspension (1 wt-%) in isopropanol (right).
**Figure 3****.** Differential thermal analysis (DTA) and thermogravimetry (TG) of citrate-capped Cu⁰ nanoparticles as performed in nitrogen atmosphere (a) as well as in air (b) (total weight: 16 mg).
**Figure 4****.** XRD pattern of nanoscaled Cu⁰ powders when stored for different periods in time in contact to air: a) complete XRD pattern; b) detailed region around the main (111) Bragg peak with the corresponding FWHM values (bulk-Cu as a reference: ICCD-No. 3065-9026).
**Figure 5****.** XRD patterns, photos and FT-IR spectra of sintered Cu⁰ powders.
**Figure 6****.** Sheet resistance of porous Cu⁰ thin-films on glass substrates subsequent to sintering in vacuum at temperatures up to 500 °C and in comparison to a sheet of bulk-Cu.
**Figure 7****.** Capillary-based microreactor system
**Figure 8****.** Photos and DLS analysis of citrate-capped In⁰ nanoparticles: samples A, B and C as supension in ethanol.
**Figure 9****.** X-ray powder diffraction pattern of citrate-functionalized In⁰ nanoparticles of sample A, B, C as well as sample C stored for 8 weeks as a powder in contact to air (D) (bulk-In⁰ as a reference (E), ICDD-No. 3065-929).

### Materials characterization and analytical tools

*Scanning electron microscopy (SEM)* was performed on a Zeiss Supra 40 VP, using an acceleration voltage of 20 kV and a working distance of 4 mm to analyse the size distribution and shape of the nanoparticles. All samples were prepared by evaporating a single drop of a dispersion of the as-prepared Cu⁰ nanoparticles in isopropanol in air at ambient temperature.

*Scanning transmission electron microscopy* (STEM) was conducted on the same electron microscope as the above SEM analysis, using an acceleration voltage up to 30 kV and a working distance of 4 mm. STEM samples were prepared on holey carbon-film copper-grids at room temperature. Mean diameters of the nanoparticles were deduced by statistical evaluation of at least 200 particles. Note that systematically different diameters obtained by SEM and STEM imaging are related to different electron-detection modes and interaction volumes of the primary electrons with the sample. While SEM images are based on backscattered secondary electrons that were detected by an Everhart-Thornley detector, only transmitted electrons are collected in the STEM mode of operation.

*Dynamic light scattering (DLS)* was performed with a Nanosizer ZS from Malvern Instruments (equipped with a He-Ne laser (633 nm), detection via non-invasive back-scattering at an angle of 173°, 256 detector channels, polystyrene cuvettes). For analysis, the as-prepared nanoparticles were redispersed in diethylene glycol by ultrasonic treatment for 15 min.

*X-ray powder diffraction (XRD) analysis* was carried out with a Stoe Stadi-P diffractometer using Ge-monochromatized Cu-K_{α1} radiation.

*Fourier-transform infrared spectra (FT-IR)* were recorded on a Bruker Vertex 70 FT-IR spectrometer using KBr pellets. For this purpose 400 mg of dried KBr were carefully pestled with 1 mg of the sample and pressed to a thin pellet. All spectra of the nanoparticles were subjected to a correction of scattering effects to allow for comparison to reference spectra.

*UV-Vis spectra* were recorded with a Varian Cary Scan 100 using dispersions of the Cu⁰ nanoparticles in isopropanol. Measurements were performed in transmission geometry since a significant contribution from particle scattering is not expected with particle diameters below 50 nm.

*Differential thermal analysis and thermogravimetry* (DTA-TG) were performed with a Netzsch STA 409C instrument, using corundum crucibles for the sample and as a reference. The samples were heated in air or under nitrogen up to 800°C with a heating rate of 5°C min⁻¹.

*Conductivity measurements* were performed via four-point probing using a Keithley system (485 Autoranging picoammeter, 199 System DMM/Scanner, 230 Programmable voltage source). The electrodes were placed in a row and a distance of 1.0 mm to each other. To calculate the sheet resistance, a geometrical correction factor equal to *π*/*ln* 2 was applied (L. B. Valdes, Proceedings IRE, 1952, 40, 445).

### Example 1: Batch-synthesis of Cu⁰ nanoparticles

All chemicals were applied as received. This includes: copper(II)chloride dihydrate (99 %, Riedel de Haën); sodium boronhydride (95 %, Riedel de Haën); trisodium citrate dihydrate (99 %, Acros); diethylene glycol (≥99 %, Merck); ethanol (98 %, Seulberger); isopropanol (technical grade, Seulberger); sodium hydroxide (≥99 %, Riedel de Haën). Aqueous solutions were prepared by using demineralised water.

*Synthesis of Cu⁰ nanoparticles:* A typical synthesis was performed under dynamic nitrogen purging in order to exclude moisture and oxygen during the reaction. 85.3 mg of CuCl₂·2H₂O and 100.0 mg of trisodium citrate dihydrate were dissolved in 20.0 mL of diethylene glycol and heated to 100°C under vigorous stirring. During heating the clear green solution turned to a green-deep cyan suspension which indicates the formation of nanoscaled Cu-comprising nanoparticles (Figure 1). Although these Cu-comprising nanoparticles turned out as non-crystalline, its chemical composition is qualitatively clarified based on the characteristic cyan color and quantified via infrared spectra that show a strong and broad (OH)-vibration (v(OH): 3600-3200 cm⁻¹). Nucleation of the Cu-comprising nanoparticles is controlled by citrate as a surface capping that was added to the initial solution. Its presence is confirmed by FT-IR spectra, too (Figure 1). Dynamic light scattering, furthermore, evidences a narrow size distribution, however, with a mean diameter of 21(5) nm.

Meanwhile, 10.0 mL of diethylene glycol were heated to 100°C, too. At this temperature, 75.7 mg of NaBH₄ were added and dissolved under vigorous stirring. When the NaBH₄ had been completely dissolved, this solution was injected to the first-made Cu(II) solution. With this measure, the color of the suspension instantaneously turned brownish black due to the formation of copper nanoparticles. After natural cooling to room temperature, the as-prepared nanoparticles were collected by centrifugation and washed three times by sequential redispersion in and centrifugation from an 1:1 mixture of ethanol and isopropanol. Colloidally stable suspensions were obtained by redispersing the washed nanoparticles in isopropanol; powder samples were yielded by drying the solid remnant for 12 h at ambient temperature in air. The Cu⁰ nanoparticles were obtained with a yield of 35 mg. Taking an amount of 10 % of citrate as a surface capping into account, this represents a yield near 100 %.

To verify the influence of the intermediate Cu-comprising nanoparticles precipitation on the particle stability further experiments at different pH values/ [OH-] were carried out. Typically, the nanoparticles showed an increased tendency for agglomeration and/or reoxidation if the Cu-comprising nanoparticles precipitation was prevented during the synthesis. This points to the essential role of citrate as a capping agent that is adsorbed via its carboxyl groups to the OH-terminated surface of the intermediate Cu-comprising nanoparticles (Figure 1). The protective shell also guarantees for an adequate stabilization of the Cu⁰ nanoparticles right after the chemical conversion of the hydroxide.

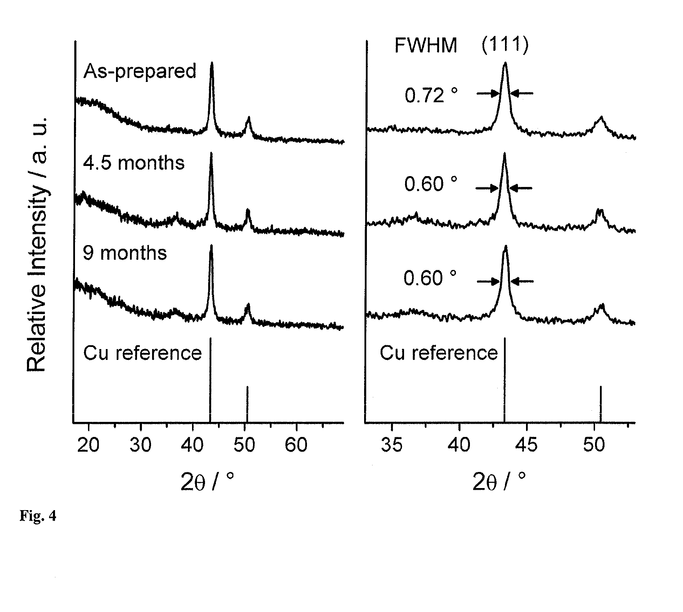

Subsequent to synthesis and purification, the as-prepared Cu⁰ nanoparticles were resuspended in isopropanol or DEG, forming deep black suspensions. Adequately diluted suspensions (i.e. Cu⁰≤1 wt-%) do not show any appreciable sedimentation for weeks (Figure 4). If the particle concentration exceeds 1 wt-%, the suspensions still show just a minor sedimentation after a couple of days. Size, size distribution and degree of agglomeration of Cu⁰ in DEG were investigated by dynamic light scattering (Figure 1). To this concern, a narrow size distribution of 15-45 nm and a mean diameter of 21(4) nm were obtained. This value is well in accordance with the size of the initial Cu(OH)₂ nanoparticles, too. In addition to DLS, particle diameter and size distribution of Cu⁰ are confirmed by electron microscopy with a value of 20-30 nm.

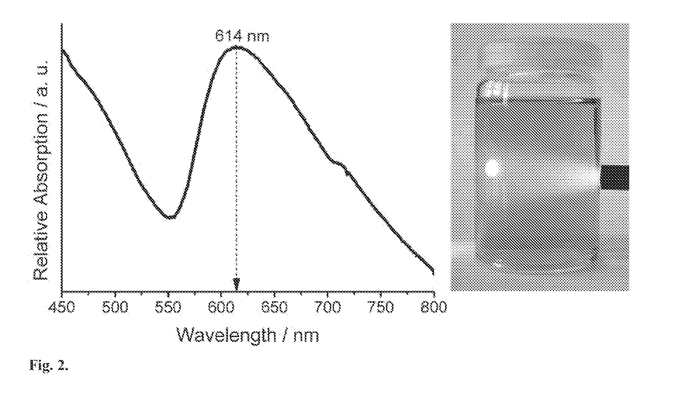

X-ray powder diffraction pattern of as-prepared Cu⁰ indicate all characteristic Bragg peaks of elemental copper and suggest the absence of appreciable amounts of crystalline impurities such as Cu₂O, CuO, CuCO₃ or Cu(OH)₂ (cf. Figure 4). Based on the full-width-at-half maximum of the (111) Bragg peak, the crystallite size can be deduced to 23 nm via the Scherrer formalism. This value is in good agreement with the mean particle size as determined by DLS and SEM. Since Cu⁰ nanoparticles exhibit a characteristic surface-plasmon resonance in the visible spectral range, the presence of copper metal can also be confirmed by its optical properties. To this concern, UV-Vis spectra of Cu⁰ suspensions in isopropanol were recorded (Figure 2). Thus, the absorption maximum was determined at a wavelength of 614 nm, which is in good agreement to literature data (i.e. around 600 nm) (P. K. Khanna et al. Mater. Lett. 2007, 61, 4711; Manjeet Singh, I. et al. Colloids and Surfaces A: Physicochem. Engineer. Aspects 2010, 359, 88.). Thus, the optical properties indicate the surface of the nanoparticles to consist of elemental copper.

FT-IR spectra of the as-prepared Cu⁰ nanoparticles clearly evidence the presence of citrate as a surface capping. Although weak in intensity, the characteristic vibrations at 3650-3300 cm⁻¹ (v(OH)), 1750-1250 cm⁻¹ (v(COO)) and the fingerprint area (1200-800 cm⁻¹) are well in agreement to spectra of bulk-trisodium citrate as a reference (Figure 1). As the Cu⁰ nanoparticles were washed carefully before drying and preparing the IR samples, this finding indicates that the citrate is adsorbed on the nanoparticle surface during the reaction and allows an efficient stabilization and passivation of the copper surface.

To determine the amount of citrate adsorbed on the Cu⁰ nanoparticle surface, thermogravimetry (TG) was involved (Figure 3a). For sample preparation, the as-prepared Cu⁰ was washed as described above and carefully dried in vacuum at ambient temperature in order to remove all excess of solvents. First, the TG was monitored under nitrogen atmosphere to avoid any oxidation of the nanoparticles. Here, a minor weight loss of 1.8 % is observed up to temperatures of 220 °C. This is ascribed to sleight amounts of solvents remaining on the particle surfaces and to the dehydration of citrate (i.e. >175 °C). In addition, a weight loss of 7.6 % occurred between 220 and 280 °C, followed by 1.7% up to 410 °C. This finding is in accordance with the thermal decomposition of surface-bound citrate to form methyl maleic anhydride or acetone and the simultaneous evaporation of the decomposition products. Note, that the pyrolysis of citrate is shifted to higher temperature due to the presence of the oxygen poor nitrogen atmosphere (M. Samim, N. K. Kaushik, A. Maitra, Bull. Mater. Sci. 2007, 30, 535). When heating even further to 800°C, the sample weight remains almost constant, indicating that no oxidation to Cu₂O or CuO occurred under nitrogen atmosphere. Altogether, TG of citrate-capped Cu⁰ nanoparticles exhibits a total weight loss of 11.5 % and evidences the presence of a considerable amount of about 10 wt-% of citrate as the surface capping on the as-prepared Cu⁰ nanoparticles.

To evaluate the thermal oxidation of the Cu⁰ nanoparticles, TG measurements were secondly performed in air (Figure 3b). Therefore, the Cu⁰ sample was again washed as described above and carefully dried in vacuum. Now, TG shows a first weight loss of 1.0 % at temperatures up to 115 °C that again indicates a minor loss of solvent residues. In contrast to the TG under nitrogen, a significant increase in weight is observed next in the ranges of 115-240 °C (+13.0 %) and 240-310 °C (+5.5 %). This increased weight is in accordance with an oxidation of Cu⁰ to Cu₂O (calc: +12.6 %) in a first step, followed by oxidation to CuO (calc: +12.6 %). When considering that this increase in weight is superimposed by the citrate-related weight losses of -1.8% (20-220 °C) and -7.5 % (220-280 °C), such oxidation is in accordance to the expectation. Moreover, CuO is indeed identified by XRD analysis as the thermal remnant of the TG performed in air. Most remarkably, the citrate-capped Cu⁰ nanoparticles do not show any oxidation in air up to temperatures of 115 °C. Beside the long-term stability at ambient conditions, this finding underlines the outstanding stability of the as-prepared Cu⁰ nanoparticles.

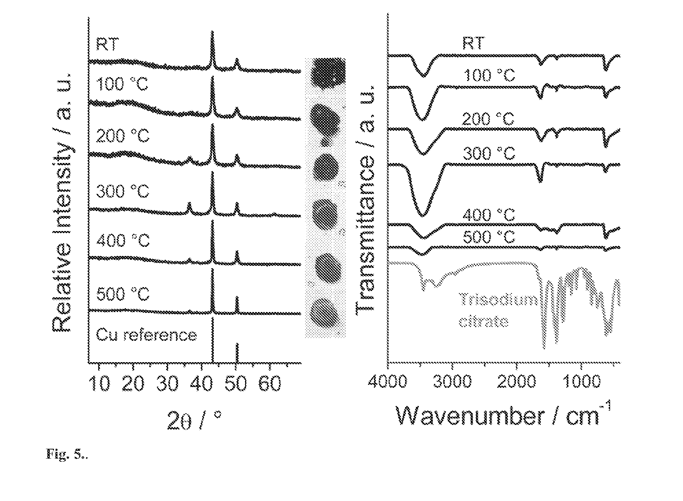

To quantify the stability of citrate-capped Cu⁰ at ambient conditions and to determine its oxidation stability against air and moisture, X-ray diffraction pattern were monitored (Figure 5). To this concern, washed and dried Cu⁰ samples were deposited in an open plastic case that was in contact to air. With steps of 20 days up to in sum 120 days, the Cu⁰ powder sample were investigated by XRD to verify the formation of copper oxides (i.e. Cu(OH)₂, Cu₂O, CuO, CuCO₃) and to indicate the occurrence of re-oxidation processes. Accordingly, powder diffraction patterns indicate just a slight amount of Cu₂O (Cu₂O (111) at 36.4 °2θ). Minor differences of, for instance, the signal-to-noise ratio are related to statistical differences when preparing the samples for X-ray diffraction analysis. The most relevant source of error regarding this type of analysis would be the formation of an amorphous oxidation product. Since any oxidation would occur from the outside to the inside of the Cu⁰ nanoparticles, growing of such an oxidized shell could be followed upon two effects: a) the Bragg peaks of the metallic Cu⁰ core would become broader with the proceeding oxidation; b) along with the consumption of Cu⁰, the intensity of Bragg peaks related to Cu⁰ would decrease. A detailed consideration of the most intense Bragg peak of Cu⁰ indicates that both effects do not occur on a time scale of 9 months (Figure 4). In sum, these findings reliably evidence the stability of the as-prepared citrate-capped Cu⁰ nanoparticles at ambient conditions in air.

### Layer formation with Cu⁰ nanoparticles and its conductivity

Conductive layer of the above prepared Cu⁰ nanoparticles were prepared via drop-coating on glass plates. To this concern, about 20 drops of a 1 wt% suspension of the washed copper nanoparticles in isopropanol were sequentially placed on the surface of a cleaned glass plate. In terms of controlled and fast drying, the glass plates were placed on a heating plate and heated to 50 °C in air. The dried samples were sintered thereafter for 30 min at temperatures up to 500 °C under vacuum. Subsequent to cooling to room temperature in vacuum, the conductivity of the Cu⁰ thin-films was measured by four-point probing. To elucidate the structure and composition of the Cu⁰ thin-films, the layers were partly removed from the glass plate by scratching with a spatula. The obtained cross-sections were used for electron microscopic characterization; the removed powder was analyzed by XRD and FT-IR.

Cross-sections of all resulting Cu⁰ thin-films - prior and subsequent to sintering - were investigated by electron microscopy. Thus, a layer thickness of 20-30 µm was obtained for the as-deposited layer. Herein, the primary Cu⁰ nanoparticles are naturally agglomerated, but nevertheless clearly visible with its initial particle size of 20-30 nm. Although the Cu⁰ nanoparticles are in intimate contact to each other, high resolution images indicate a significant porosity inside of the as-deposited thin-film. With the thermal sintering in vacuum, the particle size and layer thickness remains almost unaffected up to temperatures of 300 °C. Cross-sections of thin-films sintered at 400 and 500 °C, in contrast, show a significant reduction of the layer thickness to 16 and 9 µm, respectively. Moreover, the formation of sinter-necks between the individual particles becomes clearly obvious. Both effects - the reduced layer thickness as well as the observed sinter-necks - indicate the sintering of the nanoparticles to form infinite Cu⁰ sponges at temperatures above 300 °C. The area of fracture of sintered layers even shows a growth of copper needles that exhibit the diameter of the initial particle size and a length of some microns.

Sintering of the as-deposited Cu⁰ thin-films is confirmed by XRD pattern of the sintered layers (Figure 5). While the full-width-at-half maximum (FWHM) of the (111) Bragg peak remains constant up to a temperature of 300 °C, higher temperatures of sintering go along with a decreased peak width and points to a growth of the crystallites. Note that a formation of impurity phases such as Cu(OH)₂, Cu₂O, CuO or CuCO₃ observed only with minor concentrations. In accordance with sintering and crystallite growth the color of the Cu⁰ powders changes from deep black to the characteristic light right of the bulk-metal (Figure 5).

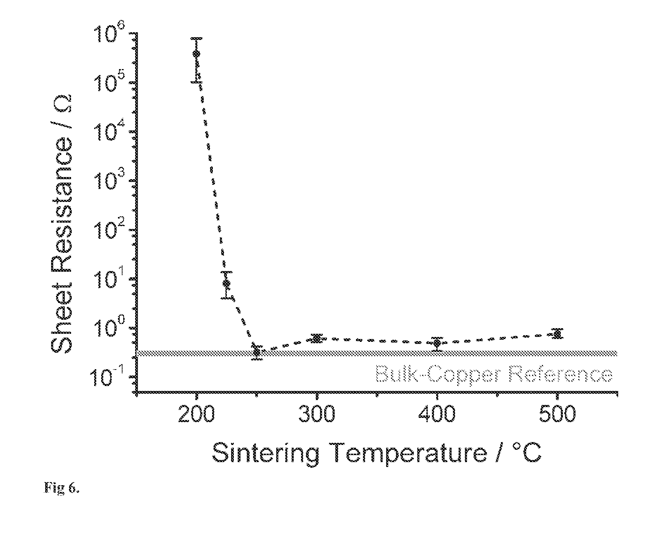

Finally, the conductivity of deposited and sintered porous Cu⁰ thin-films was measured via four-point probing (Figure 6).

Although, no significant conductivity could be measured for the as-deposited Cu⁰ thin-films and the Cu⁰ layers sintered at 100 °C, an increase of the temperature to 200 °C already lead to a sheet resistance of 1.0·10⁵ Ω_{□}. When sintering the as-deposited porous Cu⁰ thin-films at 300 °C in vacuum, the resistivity drops dramatically by 6-7 orders in magnitude to a sheet resistance of 0.5-0.7 Ω_{□}. A further increase of the sintering temperature does not lead to any significant improvement (Figure 6). This finding is attributed, on the one hand, to the citrate-capping, and on the other hand, to the grain boundaries between the individual Cu⁰ nanoparticles. And the coincidence of this jump in conductivity with the weight loss obtained from thermogravimetry (cf. Figure 3) is well in accordance with the model and explanation.

For direct comparison of the as-deposited porous Cu⁰ thin-films, an HCl-etched copper plate with a thickness of 1.0 mm was measured as a reference under identical conditions, too. For the non-etched metal sheet a sheet resistance of 6570 Ω_{□}, for the etched metal sheet a resistance of 0.27-0.35 Ω_{□} were measured. The resistance is comparable to the porous Cu⁰ layer with 0.23-0.42 Ω_{□} and confirms a bulk-like conductivity of the latter. Based on the mean layer thickness of about 20 µm of the porous Cu⁰ thin-films, the specific resistance was calculated as 8.4·10⁻⁴-4.6·10⁻⁴ Ω cm. Although this value points to an excellent conductivity, a mismatch to the literature data of bulk copper (1.7·10⁻⁶ Ω cm) is obvious. This is attributed to the difficulty of extracting the "real" thickness of a porous layer and the limited accuracy of the measuring method. To this concern, SEM images show a porosity of >50 % . Estimating the effective thickness of a (non-porous) layer to about 10 µm, in contrast, results in a resistivity of 3.2·10⁻⁴ Q cm.

Note that all experiments regarding layer deposition were performed without any optimization of those parameters that are relevant for real technical inks and its printing (e.g., viscosity, solids content, type of solvent, substrate pre-conditioning) and thereby increased conductivities are to be expected while applying professional printing technologies.

In order to determine the oxidation stability of the sintered Cu⁰ thin-films, the layers were stored in air under ambient temperature for several months. X-ray diffraction pattern were recorded after 7 months for the layer sintered at 400 °C. Neither an increase of the intensity of the Bragg peak related to Cu₂O nor a decrease of the Bragg peaks related to Cu⁰ are observed.

### Example 2: Continuous synthesis of Cu⁰ nanoparticles

170.5 mg (1 mmol) CuCl₂·2H₂O and 188.2 mg (0.64 mmol) trisodium citrate (dihydrate) were dissolved in 40 mL diethylene glycol (DEG) under dynamic nitrogen purging in a Cu-precursor-container. Using an oil bath the mixture was heated up to a bath temperature of 100 °C. A green-blue homogeneous suspension was obtained.

The reducing solution was prepared in a NaBH₄-solution container by dissolving 200 mg NaOH in 40 mL diethylene glycol so a diethylene glycol sodium hydroxide solution is obtained first and then adding 151.3 mg (4 mmol) sodium borohydride. The high pH helps stabilizing the sodium borohydride solution. This solution should be prepared freshly and stored at 4 °C before use.

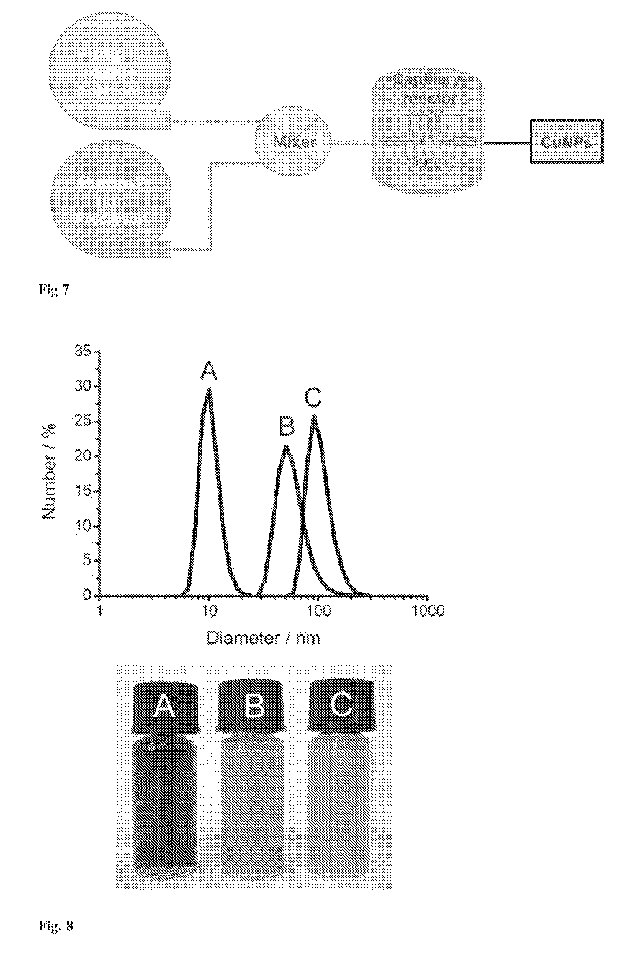

Both copper precursor and NaBH₄ reducing solution at room temperature were pumped in to the capillary-based continuous microreaction system as shown in Fig. 7 comprising a pump (Shimdadzu LC 8A Prep Pump (HPLC Pump)), a micromixer (stirred microvessel of 50 mm3 volume using a magnetic stirrer and having side inlet and top outlet made of PTFE) connected to a capillary microreactor made of 2-10 meter PTFE capillary tube with inner diameter of 0.5-1 mm, heated with a oil bath at a flow rate of 2 mL/min at room temperature.

A black suspension was observed out of the microreaction system, which indicated the formation of Cu nanoparticles. The Cu nanoparticles were collected by centrifugation and washed with the mixture of ethanol and isopropanol solution. The particle products were dried at 50-100 °C in vacuum.

Analyses confirmed results obtained for nanoparticles of example 1.

### Example 3: Batch-preparation of In⁰ nanoparticles

The synthesis of the In⁰ nanoparticles was performed under dynamic nitrogen purging. All purification and analytic steps were performed under air. All chemicals were applied as received.

In⁰ nanoparticles were prepared via a citrate-assisted polyol reaction with diethylene glycol (DEG, Merck, 99 %) as the polyol and solvent. First, 2.5 mmol (735 mg) InCl₃·4H₂O (Aldrich, 99.9 %) and 1.9 mmol (500 mg) disodium citrate hydrate (Aldrich, 99 %) were filled in a three-necked flask together with 100.0 mL of DEG. Under dynamic nitrogen purging and vigorous stirring, the solution was heated to 100 °C with an oil bath. Subsequently, 25.0 mmol (945.0 mg, In³⁺:BH₄⁻=1:10, sample A), 7.5 mmol (284 mg, In³⁺:BH₄⁻=1:3, sample B) and 5.0 mmol (190 mg, In³⁺:BH₄⁻=1:2, sample C) NaBH₄ (Riedel de Haën, 95 %) were dissolved in 2.0 mL of demineralized water and rapidly injected to the transparent, colourless DEG solution. Within seconds, the colourless transparent solutions changed its colour to yellow-brown and finally dark brown (sample A), brownish-grey (sample B) and grey (sample C). The nanoparticles were collected by centrifugation of the resulting suspension and were finally washed by sequential redispersion in and centrifugation from ethanol (sample B and C). The suspension of sample A was added with 50.0 mL of satured aqueous NaCl and stirred for 10 min. After centrifugation the solid remnant was washed by redispersion in and centrifugation from water and ethanol. Colloidal stable dispersions were prepared by resuspending the nanoparticles in ethanol. To obtain powder samples the nanoparticles were dried at ambient temperature in air.

The size of the In⁰ nanoparticles can be controlled just by varying the amount of borohydride that ranges from 25.0 mmol (sample A) and 7.5 mmol (sample B) to 5.0 mmol (sample C).

Size and size distribution of the as-prepared In⁰ nanoparticles was first examined by dynamic light scattering (DLS) (Figure 8). To this concern, the In⁰ nanoparticles were carefully washed by sequential centrifugation/redispersion and finally resuspended in ethanol. DLS analysis evidence a narrow size distribution and a clear difference of the mean hydrodynamic diameter: 10(2) nm (sample A), 58(19) nm (sample B) and 91(27) nm (sample C). In accordance to these data, suspension A is optically transparent, whereas suspensions of samples B and C become more and more translucent (Figure 8).

Scanning electron microscopy (SEM) confirms the spherical shape as well as the narrow size distribution. Here, the In⁰ nanoparticles exhibit mean diameters of 8 nm (sample A), 55 nm (sample B) and 105 nm (sample C). Due to the uniform shape, partly dense-packed monolayers were obtained via solvent evaporation on the SEM specimens.

The excellent colloidal stability of the as-prepared In⁰ nanoparticles is related to the citrate-capping on the particles surfaces. FT-IR spectra of the as-prepared In⁰ clearly evidence the presence of citrate as a surface capping. Although weak in intensity, the characteristic vibrations at 3665-3300 cm⁻¹ (v(OH)), 1650-1250 cm⁻¹ (v(COO) and the fingerprint area (1250-800 cm⁻¹) are well in agreement to citrate reference spectra.

Considering the less-noble character (E₀(In) = -0.34 V) of In⁰, fast reoxidation of the nanoparticles would have been expected for suspensions in protic solvents and contact to air.

As-prepared In⁰ in DEG is indeed of limited stability regarding agglomeration and reoxidation if the citrate-capping was left out: complete decolorization and sedimentation due to reoxidation of In⁰ to In(OH)₃/In₂O₃ was observed within 12-24 hours.

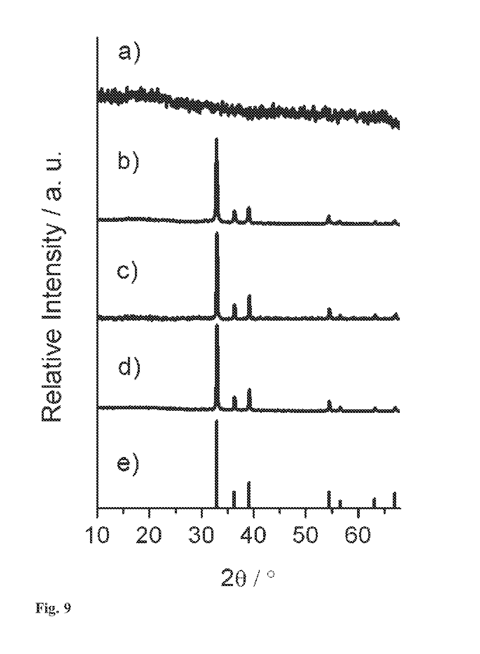

In contrast, the citrate-capped In⁰ nanoparticles as prepared in the present invention surprisingly did not show any reoxidation neither as a suspension nor as a powder. This is qualitatively validated by its color and quantified by X-ray powder diffraction pattern (XRD) (Figure 9).

To this concern, the centrifuged and washed samples were dried at ambient temperature in air. XRD pattern of sample B and C show all characteristic Bragg peaks of elemental indium and indicate the absence of (crystalline) impurities (e.g. In(OH)₃, In₂O₃). Even when powders of In⁰ were left for 8 weeks in contact to air neither any alteration nor any contamination occurred. Based on the integral width of the (101) reflection, a crystallite size of 80-90 nm can be estimated via the Scherrer equation. This is in resonable agreement with the values obtained by DLS and SEM. In the case of sample C such estimation is not meaningful, since broadening of Bragg peaks with particles exceeding diameters of 100 nm is in the range of the instrumental broadening.

## Claims

1. Method for the synthesis of nanoparticles comprising one or more oxidation sensitive metals via reduction of a metal salt with a reducing agent in the presence of bi- or tri-functional organic carboxylic acids as a capping agent in a high boiling alcohol.

2. Method according to claim 1 wherein the metal salt and the reducing agent are used in a ratio of Me-salt:reducing agent from 1:0.5 to 1:25.

3. Method according to one of the claims 1 or 2 comprising two steps: a) preparation and nucleation of capped Me-comprising nanoparticles, b) reduction of the intermediate capped Me-comprising nanoparticles to Me⁰ by reduction via the reducing agent.

4. Method according to claim 3 wherein a [OH⁻] concentration of 0.01 to 0.1 M is used to promote Me(OH)ₓ nucleation.

5. Method according to one of the claims 1 to 4 conducted batchwise or in a continuous way.

6. Method according to one of the claims 1 to 5 wherein oxidation sensitive metals have Redox-potential from -0.9 to +0.9 V.

7. Method according to claim 6 wherein oxidation sensitive metal is In, Cu, Zn, Fe, Sn, Bi, Pb or mixture thereof.

8. Nanoparticles comprising one or more oxidation sensitive metal obtainable by the method according to one of the claims 1 to 7.

9. Nanoparticles according to claim 8 with a mean diameter of 1 to 160 nm.

10. Nanoparticles according to one of the claims 8 or 9 comprising In, Cu, Zn, Fe, Sn, Bi, Pb metal or mixture thereof.

11. Ink comprising the nanoparticles according to one of the claims 8 to 10.

12. Device comprising the nanoparticles according to one of the claims 8 to 10.
